Europäisches Patentamt

European Patent Office

Office européen des brevets

(11) Numéro de publication: **0 446 828 A1**

## (12) DEMANDE DE BREVET EUROPEEN

(21) Numéro de dépôt: **91103676.2**

(51) Int. Cl.5: **H03G 11/00**

(22) Date de dépôt: **11.03.91**

(30) Priorité: **15.03.90 FR 9003335**

(43) Date de publication de la demande:
**18.09.91 Bulletin 91/38**

(84) Etats contractants désignés:
**DE FR GB IT SE**

(71) Demandeur: **ALCATEL ESPACE**
**11, avenue Dubonnet**
**F-92407 Courbevoie Cédex(FR)**

(72) Inventeur: **Pouysegur, Michel**
**51, av.V.Ségoffin**
**F-34100 Toulouse(FR)**
Inventeur: **Parra, Thierry**

**c/o Laas-CNRS, 7, avenue du Colonel Roche**
**F-31077 Toulouse(FR)**
Inventeur: **Gayral, Michel**
**c/o Laas-CNRS, 7, avenue du Colonel Roche**
**F-31077 Toulouse(FR)**
Inventeur: **Graffeuil, Jacques**
**c/o Laas-CNRS, 7, avenue du Colonel Roche**
**F-31077 Toulouse(FR)**
Inventeur: **Sautereau, Jean-François**
**c/o Laas-CNRS, 7, avenue du Colonel Roche**
**F-31077 Toulouse(FR)**

(74) Mandataire: **Weinmiller, Jürgen et al**
**Lennéstrasse 9 Postfach 24**
**W-8133 Feldafing(DE)**

(54) Dispositif limiteur a transistor a effet de champ.

(57) L'invention concerne un dispositif limiteur à transistor à effet de champ, dont le circuit de polarisation se compose de deux alimentations à tension constante (Vgs, Vds): l'une (Vgs) sur la grille l'autre (Vds), sur le drain une charge résistive (Rg) étant disposée en série avec l'alimentation de la grille de ce transistor (10).

Application notamment au domaine des télécommunications spatiales.

FIG. 1

EP 0 446 828 A1

L'invention concerne un dispositif limiteur à transistor à effet de champ.

Dans un certain nombre de systèmes actifs micro-ondes on est amené à utiliser des dispositifs limiteurs dont la fonction est de délivrer une puissance constante en sortie quelle que soit la puissance appliquée à l'entrée. Aujourd'hui ces dispositifs sont en général réalisés au moyen de transistors à effet de champ (TEC) utilisés en régime de saturation au delà de leur point de compression.

Pour certaines applications spécifiques il convient, de plus, que la phase du signal délivré par le dispositif limiteur reste constante lorsque le signal d'entrée varie. Or l'expérience montre que parfois l'utilisation de certains types de transistors à effet de champ permet de satisfaire à cette nécessité tandis que d'autres types de transistors à effet de champ ne permettent pas de s'affranchir de variations de phase pouvant atteindre quelques degrés.

L'idée de départ consiste à réaliser un dispositif limiteur à transistor à effet de champ présentant de bonnes performances en ce qui concerne la variation de sa phase d'insertion ; c'est-à-dire du rapport des phases du signal en entrée et en sortie du dispositif limiteur en fonction de la puissance injectée en entrée.

L'essentiel de la variation de la phase d'insertion observée sur les dispositifs limiteurs à transistors à effet de champ est due au déphasage introduit par ces transistors lorsqu'ils sont utilisés dans leur zone de compression, c'est-à-dire la zone dans laquelle pour une puissance d'entrée qui augmente leur puissance de sortie ne varie plus.

L'invention a donc pour objet un dispositif limiteur à transistor à effet de champ permettant de minimiser la variation de la phase d'insertion introduite par les transistors à effet de champ en fonctionnement saturé.

Il n'existe que très peu de travaux publiés à ce jour qui traitent de ce sujet.

Seul un article de Serge Bertrand intitulé "Amplificateur-limiteur à TEC sans déphasage - Application dans la bande 7.9 - 8.4 GHz" ("Journées nationales micro-ondes" de Nice ; pages 146 et 147 ; Juin 1987), qui décrit les variations de phase d'un transistor à effet de champ, fonction de la puissance d'entrée et de l'impédance présentée en sortie, montre la faisabilité d'un limiteur à transistor à effet de champ avec un déphasage optimisé. Il décrit également un module cascadable ainsi qu'un limiteur possédant un déphasage inférieur à 2° dans 21 dB de dynamique pour la bande 8.1-8.3 GHz.

Cet article décrit donc la réalisation d'un limiteur à transistor à effet de champ AsGa présentant d'excellentes performances en ce qui concerne la variation de la phase d'insertion (inférieure à 2° pour une puissance d'entrée variant de Pe = - ∞ à Pe = Pe$_{1dB}$ + 10 dBm). Afin d'arriver à ce résultat, cet article ne décrit pas une technique de circuit à proprement parler, mais une méthode de tri préalable des transistors afin de sélectionner ceux qui présentent une variation de la phase d'insertion minimale ; Les transistors ainsi sélectionnés étant alors utilisés pour réaliser le limiteur.

Par contre l'invention permet, à priori, de limiter la variation de la phase d'insertion des transistors à effet de champ utilisés en fonction de limitation, ce qui permet de s'affranchir de cette technique de tri préalable.

L'invention propose à cet effet un dispositif limiteur à transistor à effet de champ, dont le circuit de polarisation se compose de deux alimentations à tension constante : l'une sur la grille l'autre sur le drain ; une charge résistive étant disposée en série avec l'alimentation de la grille de ce transistor, caractérisé en ce que cette charge, destinée à maintenir constante la capacité d'entrée du transistor et par conséquent à limiter les variations de phase introduites par ce transistor, est constituée par une résistance de faible valeur telle que Rg ≃ Ro x 400/Z; où Z représente la largeur de grille du transistor exprimée en micromètres et où Ro a pour valeur 20Ω Rg étant exprimé en ohms.

Ainsi, grâce à la charge on augmente la polarisation inverse de grille qui s'accompagne d'une décroissance de la capacité d'entrée de manière à compenser la croissance de la capacité provoquée par le passage en direct de la grille. On obtient, ainsi, une diminution de 50% de la variation de la phase d'insertion du dispositif limiteur.

Avantageusement cette technique simple est utilisable en technologie de circuits hybrides ou monolithiques.

Dans une réalisation avantageuse la charge résistive est constituée par une résistance de faible valeur telle que Rg ≃ Ro x 400/Z où Z représente la largeur de grille du transistor exprimé en micromètres et où Ro a pour valeur 20Ω. Plus particulièrement cette charge est inférieure à 100Ω.

Dans le cas de transistors à effet de champ de type AsGa cette charge est comprise entre 10Ω et 30Ω.

Les caractéristiques et avantages de l'invention ressortiront d'ailleurs de la description qui va suivre, à titre d'exemple non limitatif, en référence aux figures annexées sur lesquelles :

- la figure 1 illustre le dispositif de l'invention ;
- les figures 2 et 3 représentent des courbes explicatives du fonctionnement du dispositif de l'invention.

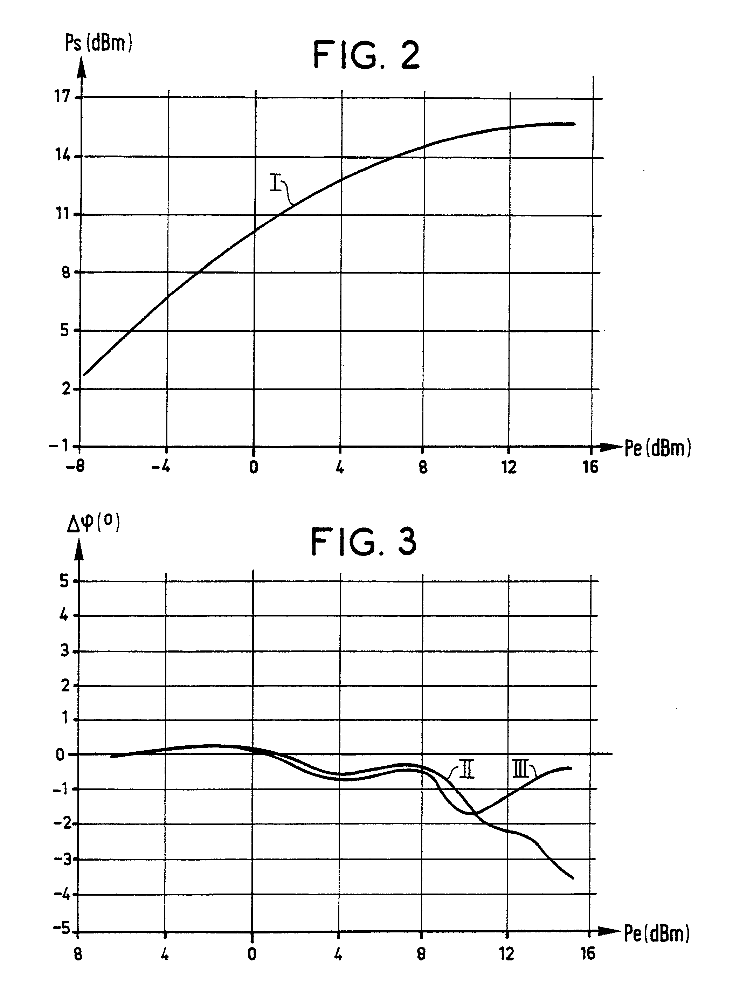

On peut mettre en évidence, tant expérimentalement que théoriquement, que la variation de phase entrée-sortie $\Delta\phi$ introduite par un transistor à effet de champ en fort régime de compression, comme représenté sur la courbe II de la figure 3, en fonction de la puissance d'entrée Pe, est essentiellement dûe à la variation de la capacité d'entrée provoquée par le passage en direct de la grille sur une fraction de l'alternance.

En général, les dispositifs de polarisation utilisés pour les transistors à effet de champ, notamment dans le domaine spatial, comportent un circuit de réaction qui maintient le courant de drain constant avec une tension de drain fixe en agissant sur la tension de grille. Mais un tel système est à proscrire pour les dispositifs limiteurs car il aggrave l'effet décrit plus haut ; en effet la capacité de grille est fonction directe de la tension de grille appliquée.

Au contraire, dans le dispositif de l'invention le circuit de polarisation se compose de deux alimentations à tension constante : l'une Vgs sur la grille, l'autre Vds sur le drain. Etant donné qu'une augmentation de la polarisation inverse de grille s'accompagne d'une décroissance de la capacité d'entrée, le dispositif de l'invention permet d'augmenter cette polarisation inverse de manière à compenser la croissance de la capacité provoquée par le passage en direct de la grille. Pour réaliser cette fonction le dispositif de l'invention comprend une résistance Rg disposée en série dans le circuit de polarisation de grille du transistor à effet de champ 10.

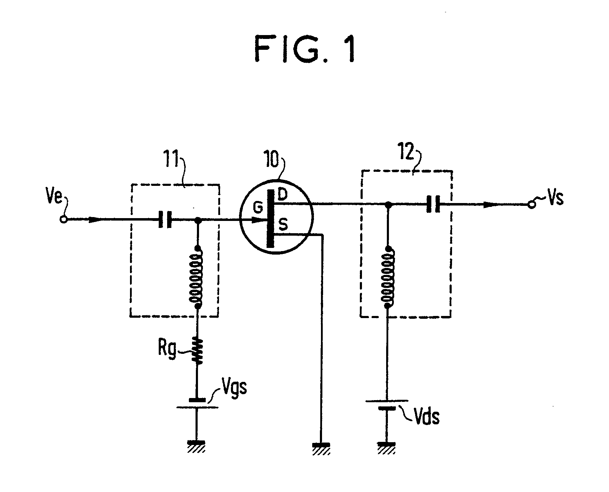

Le dispositif limiteur de l'invention, tel que représenté à la figure 1, comprend donc un transistor à effet de champ 10, deux alimentations de grille Vgs et de drain Vds, une résistance Rg disposée en série avec Vgs, et deux "Tés" de polarisation 11 et 12 disposés de part et d'autre du transistor 10 dont le rôle est de permettre de polariser ce transistor 10 et de ne perturber ni le circuit extérieur ni la propagation du signal Ve, par exemple hyperfréquence. Ces "tés" de polarisation, connus de l'homme de l'art, pour éviter que le transistor 10 n'oscille, passent une certaine gamme de fréquence, par exemple les très basses fréquences.

Dès l'apparition d'un courant sur la grille, la chute de tension dans la résistance Rg, compte tenu du sens de ce courant, provoque une augmentation de la polarisation inverse de grille qui tend à maintenir constante la capacité d'entrée et par conséquent à limiter les variations de phase introduites par le transistor 10.

La courbe III de la figure 3, qui représente la variation de phase entrée-sortie $\Delta\phi$ , en fonction de la puissance d'entrée Pe, introduite par le transistor effet de champ 10, montre que la variation maximale de la phase peut être ainsi ramenée de 3-5$^\circ$ à 2$^\circ$, Rg étant égale à 20Ω. On note aussi que l'adjonction de la résistance Rg n'a aucun effet sur la caractéristique en puissance du dispositif limiteur, comme représenté sur la courbe I de la figure 2, qui représente la variation de la puissance de sortie Ps en fonction de la puissance d'entrée Pe.

Le choix de la valeur de Rg (en général quelques ohms) est critique et dépend des caractéristiques du transistor : il peut être réalisé soit par ajustage, soit par une simulation non linéaire préalable du dispositif limiteur, à condition, pour cette seconde solution, d'avoir déterminé toutes les caractéristiques électriques du transistor.

Il est toutefois possible de déterminer approximativement la valeur de la résistance Rg par la formule empirique suivante : Rg = Ro x 400/Z où Z représente la largeur de grille du transistor utilisé exprimée en micromètres et où Ro a pour valeur 20Ω. Rg est alors exprimée en ohms.

Il faut insister sur le fait que le choix de la valeur de la résistance Rg est très important : Il permet ou non un bon fonctionnement du dispositif de l'invention. En effet, de nombreux circuits comportant des transistors à effet de champs utilisent dans le circuit de polarisation de grille une résistance série, généralement de forte valeur, destinée à protéger le transistor contre une éventuelle surcharge en courant. Mais, cette résistance n'a absolument pas l'effet recherché en ce qui concerne la minimisation de la phase d'insertion.

Les valeurs typiques de la résistance Rg pour obtenir un bon fonctionnement du dispositif de l'invention sont inférieures à 100Ω ; et plus particulièrement, pour un transistor à effet de champ de type AsGa comprises entre 10Ω et 30Ω.

Avantageusement ce dispositif limiteur de l'invention présente les caractéristiques suivantes, pour des mesures effectuées à environ 10 GHz : Pour une puissance d'entrée variant de Pe = -∞ à Pe = Pe$_{1db}$ + 12 dbm, la variation de la phase d'insertion est inférieure à 2$^\circ$ ; la résistance Rg utilisée ayant une valeur inférieure à 100 ohms.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

**Revendications**

1. Dispositif limiteur à transistor à effet de champ, dont le circuit de polarisation se compose de deux alimentations à tension constante : l'une sur la grille (Vgs), l'autre sur le drain (Vds) ; une charge résistive (Rg) étant disposée en série avec l'alimentation de la grille de ce transistor (10),caractérisé en ce que cette charge (Rg), destinée à maintenir constante la capacité d'entrée du transistor (10) et par conséquent à limiter les variations de phases introduite par ce transistor,est constituée par une résistance de faible valeur telle que Rg $\simeq$ Ro x 400/Z ; où z représente la largeur de grille du transistor (10) exprimée en micromètres et où Ro a pour valeur 20$\Omega$, Rg étant exprimé en ohms.

2. Dispositif selon la revendication 1, caractérisé en ce qu'il comprend deux "tés" de polarisation (11, 12).

3. Dispositif selon l'une quelconque des revendications 1 ou 3, caractérisé en ce que cette charge (Rg) est inférieure à 100$\Omega$.

4. Dispositif selon la revendication 3, caractérisé en ce que le transistor à effet de champ (10) est de type AsGa, et en ce que la charge (Rg) est comprise entre 10$\Omega$ et 30$\Omega$.

5. Dispositif selon l'une quelconque des revendications précédentes, caractérisé en ce que ledit dispositif est un dispositif hyperfréquence.

# FIG. 1

# FIG. 2

# FIG. 3

Office européen
des brevets

**RAPPORT DE RECHERCHE
EUROPEENNE**

Numéro de la demande

**EP 91 10 3676**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4 162 412 (D. D. MAWHINNEY)<br>* colonne 4, ligne 36 - colonne 5, ligne 2; figures 4b, 4c *<br>— — — | 1,5 | H 03 G 11/00 |
| A | NEC RESEARCH AND DEVELOPMENT. vol. 48, no. 1, 1978, TOKYO JP pages 61 - 65; S. FUKUDA et al.:: "A New Microwave Amplitude Limiter Using GaAs Field Effect Transistors"<br>* page 61, colonne de droite, alinéa 1 - page 62, colonne de droite, alinéa 2; figure 1 *<br>— — — | 1,5 | |
| A | US-A-4 737 733 (J. N. LA PRADE)<br>* colonne 3, lignes 10 - 35 ** colonne 4, ligne 19; figure 2 *<br>— — — | 1,5 | |
| A | 1985 IEEE-MTT-S International Microwave Symposium Digest, June 4-6, 1985, New York US; pages 613-616; B. R. Hallford: "30 dB of AGC from an FET"<br>— — — — — | | |

**DOMAINES TECHNIQUES
RECHERCHES (Int. Cl.5)**

H 03 G
H 03 H

Le présent rapport de recherche a été établi pour toutes les revendications

| Lieu de la recherche | Date d'achèvement de la recherche | Examinateur |
|---|---|---|
| La Haye | 19 juin 91 | BLAAS D.-L.A.J. |